# EUROPÄISCHE PATENTSCHRIFT

(11) **EP 0 683 533 B1**
(45) Veröffentlichungstag und Bekanntmachung des Hinweises auf die Patenterteilung: **22.07.1998**
(21) Anmeldenummer: 95106859.2
(22) Anmeldetag: 05.05.1995
(51) Int. Cl.: H01L 39/24

(54) **Verfahren zur Herstellung eines Supraleiters mit mehreren Hoch-Tc-Supraleiteradern**
Method of making high Tc multifilament superconductors
Procédé de fabrication de supraconducteurs à Tc élevée à filaments multiples

(30) Priorität: 18.05.1994 DE 4417426
(43) Veröffentlichungstag der Anmeldung: 22.11.1995
(73) Patentinhaber: SIEMENS AKTIENGESELLSCHAFT, 80333 München (DE)
(72) Erfinder: Hauner, Franz, Dr., D-91341 Röttenbach (DE); Tiefel, Günter, D-90766 Fürth (DE); Herkert, Werner, Dipl. Ing., D-91054 Erlangen (DE); Prölss, Norbert, D-90530 Wendelstein (DE); Neumüller, Heinz-Werner, Dr., D-91080 Uttenreuth (DE)

(56) Entgegenhaltungen:
- EP-A- 0 281 444
- EP-A- 0 302 791
- EP-A- 0 303 283
- EP-A- 0 475 466
- EP-A- 0 581 366
- K.Lange, Umformtechnik, Handbuch für Industrie und Wissenschaft, Band 2, 2.Auflage, Springer Verlag 1988, Seiten 254-256

## Beschreibung

Die Erfindung bezieht sich auf ein Verfahren zur Herstellung eines langgestreckten Supraleiters mit mehreren in einer Matrix aus Ag-Material eingebetteten Leiteradern, die ein Supraleitermaterial mit einer metalloxidischen Hoch-T_{c}-Phase enthalten. Bei diesem Verfahren werden folgende Verfahrensschritte durchgeführt:
a) Zunächst wird ein Ausgangskörper aus dem Matrix-Material mit der gewünschten Anzahl an Kernen aus einem Vorprodukt des Supraleitermaterials erstellt,
b) darauf wird dieser Ausgangskörper mehreren Verformungsschritten unterzogen
und
c) mindestens eine Wärmebehandlung wird zur Ausbildung der Hoch-T_{c}-Phase des Supraleitermaterials aus dem Vorprodukt in einer sauerstoffhaltigen Atmosphäre vorgesehen.
Ein entsprechendes Verfahren ist aus dem Beitrag von M.Wilhelm et al. mit dem Titel "Fabrication and Properties of Multifilamentary BiPbSrCaCuO-2223 Tapes" des "International Symposium on Superconductivity "(ISS'93), Hiroshima (JP), Oct. 26-29, 1993, zu entnehmen.

Es sind supraleitende Metalloxidverbindungen mit hohen Sprungtemperaturen T_{c} von über 77 K bekannt, die deshalb auch als Hoch-T_{c}-Supraleitermaterialien oder HTS-Materialien bezeichnet werden und eine LN₂-Kühltechnik erlauben. Unter solche Metalloxidverbindungen fallen insbesondere Cuprate von Stoffsystemen der Typen Y-Ba-Cu-O (Abkürzung: YBCO) oder Bi-Sr-Ca-Cu-O (Abkürzung: BSCCO) oder Bi(Pb)-Sr-Ca-Cu-O (Abkürzung: B(P)SCCO). Innerhalb einzelner Stoffsysteme können mehrere supraleitende Hoch-T_{c}-Phasen auftreten, die sich durch die Anzahl der Kupfer-Sauerstoff-Netzebenen bzw. - Schichten innerhalb der kristallinen Einheitszelle unterscheiden und die verschiedene Sprungtemperaturen aufweisen.

Mit den bekannten Hoch-T_{c}-Supraleitermaterialien wird versucht, langgestreckte Supraleiter in Draht- oder Bandform herzustellen. Ein hierfür als geeignet angesehenes Verfahren ist die sogenannte "Pulver-im-Rohr-Technik", die prinzipiell von der Herstellung von Supraleitern mit dem klassischen metallischen Supraleitermaterial Nb₃Sn her bekannt ist. Entsprechend dieser Technik wird in ein Rohr aus einem normalleitenden Material, insbesondere aus Ag oder einer Ag-Legierung, Pulver aus einem Vorprodukt des Hoch-T_{c}-Supraleitermaterials eingebracht, das im allgemeinen noch nicht oder nur zu einem geringen Teil die gewünschte supraleitende Hoch-Tc-Phase enthält. Der so zu erhaltende Aufbau wird anschließend mittels Verformungsbehandlungen, die gegebenenfalls durch mindestens eine Wärmebehandlung unterbrochen sein können, auf die gewünschte Enddimension gebracht. Danach wird der so erhaltene draht- oder bandförmige Verbundkörper zur Einstellung oder Optimierung seiner supraleitenden Eigenschaften bzw. zur Ausbildung der gewünschten Hoch-T_{c}-Phase mindestens eine Wärmebehandlung unterzogen, die wenigstens teilweise in einer sauerstoffhaltigen Atmosphäre, z.B. an Luft, durchgeführt wird. Bündelt man in an sich bekannter Weise mehrere entsprechende band- oder drahtförmige Hoch-T_{c}-Supraleiter oder deren Leitervorprodukte, so kann man auch Leiter mit mehreren supraleitenden Leiteradern, sogenannte Multifilamentleiter, erhalten, die für technische Anwendungen eine Reihe von Vorteilen bieten (vgl. den eingangs genannten Beitrag des ISS'93 oder die EP-A-0 496 281 oder die EP-A-0 504 895).

Demgemäß wird bei einer sogenannten Rundbündelungstechnik eine der Anzahl der angestrebten Leiteradern in dem supraleitenden Endprodukt entsprechende Anzahl an Leitervorprodukten zusammengefaßt, in ein Hüllrohr gesteckt und der so entstandene Körper zu einem Draht oder Band verformt. Unter einem Leitervorprodukt sei dabei ein draht- oder bandförmiges Element verstanden, das aus einem Kern aus einem Vorprodukt des gewünschten Hoch-T_{c}-Supraleitermaterials und einer metallischen Umhüllung besteht und das mindestens einem Verformungsschritt unterzogen wurde. Verwendet man Ag als Material der Umhüllung, so kann durch eine mit der EP-A-0 475 466 für Einkernleiter vorgeschlagene Kaltverformung eine Härtung des Ag-Materials erreicht werden. Diese Härtung ist einerseits erwünscht, weil dadurch bei der Herstellung von Multifilamentleitern eine gleichmäßigere Verformung eines zweikomponentigen Aufbaus eines aus einem Bündel von Leitervorprodukten und einem Ag-Hüllrohr bestehenden Ausgangskörper erreicht wird. Andererseits behindert aber diese Härtung das notwendige Kaltverschweißen der einzelnen Leitervorprodukte des Ausgangskörpers zu einem homogenen Verbund. Aufgrund dieser Schwierigkeit wird der Ausgangskörper nach jeweils einem oder mehreren Verformungsschritten vorsichtig getempert, um das Hüllmaterial der Leitervorprodukte und das Hüllrohr des Ausgangskörpers gerade so weit zu rekristallisieren, daß bei der gemeinsamen Verformung ein Kaltverschweißen der Leitervorprodukte erfolgt. Dieser Temperschritt bewirkt aber eine Verschlechterung der Verformungseigenschaften des Metall-Keramikverbundes, da das gesamte Ag-Material der Umhüllungen der Leitervorprodukte und des Hüllrohres des Ausgangskörpers weich wird.

Aufgabe der vorliegenden Erfindung ist es deshalb, das Verfahren mit den eingangs genannten Merkmalen dahingehend auszubilden, daß bei der Herstellung von Supraleitern mit mehreren Hoch-T_{c}-Supraleiteradern Probleme einer Kaltverschweißung von Leitervorprodukten untereinander und mit einem Hüllrohr nicht gegeben sind und dennoch gute Verformungseigenschaften des Metall-Keramik-Verbundes gewährleistet sind.

Diese Aufgabe wird erfindungsgemäß dadurch gelöst, daß zur Erstellung des Ausgangskörpers ein Strangpreßbolzen aus dem Matrix-Material mit der gewünschten Anzahl von Bohrungen versehen wird, die anschließend mit dem Vorprodukt des Supraleitermaterials gefüllt und gasdicht verschlossen werden, und daß dann an diesem Ausgangskörper zumindest als ersten Verformungsschritt ein Strangpressen bei einer Temperatur vorgenommen wird, die unterhalb der Rekristallisationstemperatur des Matrix-Materials liegt.

Unter einem Ag-Material wird dabei ein Werkstoff verstanden, der zumindest zum größten Teil, d.h. zu mehr als 95 Gew.-%, Ag enthält und insbesondere bis auf übliche Verunreinigungsanteile aus reinem Ag besteht.

Die mit den erfindungsgemäßen Maßnahmen verbundenen Vorteile sind insbesondere in einer schnellen und effektiven Herstellung großer Längen an Hoch-T_{c}-Supraleitern mit mehreren Leiteradern zu sehen. Dabei ist eine großvolumige Umformung mit weitgehend gleichmäßiger Verformung von Keramik und normalleitendem Ag-Material zu gewährleisten. Diese Verformungseigenschaften werden als wesentliche Voraussetzung für eine technische Herstellung von Supraleitern mit hinreichender Stromtragfähigkeit gesehen.

Vorteilhafte Ausgestaltungen des erfindungsgemäßen Verfahrens gehen aus den Unteransprüchen hervor.

Die Erfindung wird nachfolgend unter Bezugnahme auf die Zeichnung noch weiter erläutert. Dabei zeigen jeweils schematisch deren
- Figur 1: einen Ausgangskörper für das erfindungsgemäße Verfahren,
- Figur 2: wesentliche Schritte des erfindungsgemäßen Verfahrens
und
- Figur 3: eine weitere Möglichkeit zur Herstellung eines Ausgangskörpers.

In den Figuren sind sich entsprechende Teile mit denselben Bezugszeichen versehen.

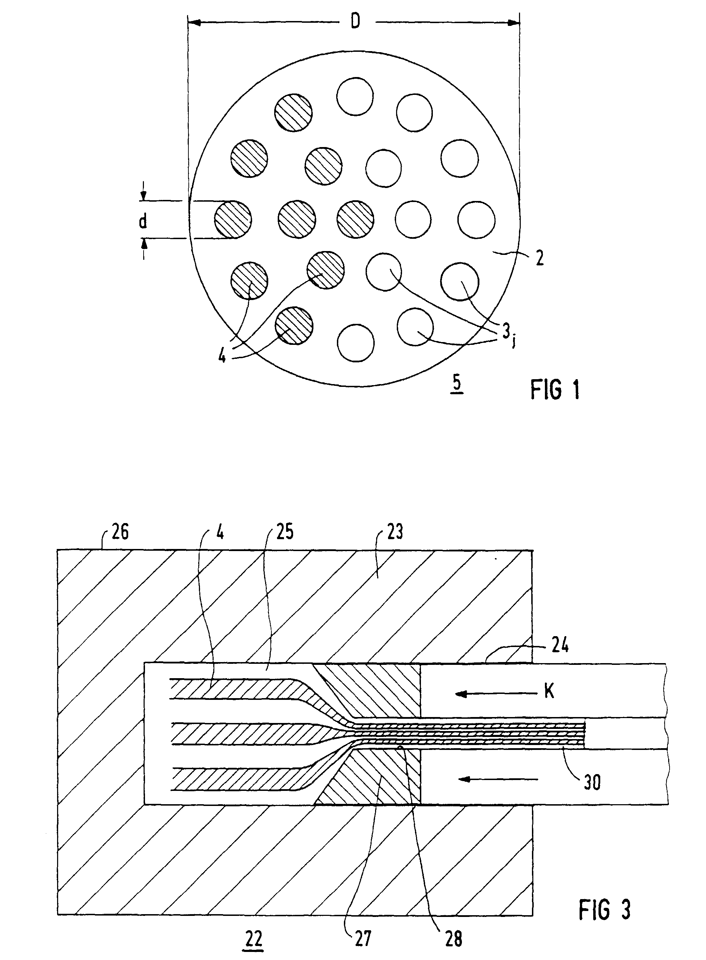

Bei dem erfindungsgemäßen Verfahren wird zunächst ein Ausgangskörper zur Herstellung eines Hoch-T_{c}-Supraleiters mit mehreren supraleitenden Leiteradern erstellt. Hierzu wird ein in Figur 1 im Querschnitt veranschaulichter Strangpreßbolzen oder Butzen 2 mit einer der gewünschten Anzahl an supraleitenden Leiteradern entsprechenden Zahl von Bohrungen 3ⱼ (mit j z.B. = 19) versehen. Mit dem Strangpreßbolzen 2 wird das Matrix-Material für die Leiteradern zur Verfügung gestellt. Als Matrixmaterial soll ein Ag-Material vorgesehen sein, das zumindest zum größten Teil, d.h. zu mehr als 95 Gew.-%, Ag enthält. Vorzugsweise kommt bis auf unvermeidbare Verunreinigungen reines Ag z.B. in Form von kaltverfestigtem Silber oder rekristallisiertem Silber in Frage. Auch pulvermetallurgisch hergestelltes Silber kann verwendet werden. Daneben ist auch dispersionsgehärtetes Silber geeignet, das z.B. einen CaO-Zusatz zwischen 0,5 und 2 Gew.-% aufweist. Der in der Figur veranschaulichte Strangpreßbolzen 2 kann beispielsweise gemaß einem konkreten Ausführungsbeispiel einen Außendurchmesser D von 48 mm und 19 Bohrungen 3ⱼ mit jeweils einem Durchmesser d von 5 mm haben. Statt der gemäß der Figur angenommenen Zylinderform des Strangpreßbolzens 2 kann dieser auch eine andere Querschnittsform wie z.B. eine Rechteckform, eine Sechseckform oder eine ovale Form aufweisen.

In die Bohrungen 3ⱼ des Strangpreßzylinders 2 wird ein sogenanntes Vorprodukt 4 des Hoch-T_{c}-Supraleitermaterials (HTS-Materials) eingebracht, beispielsweise entsprechendes Pulver eingepreßt. Als HTS-Material sind praktisch alle bekannten Hoch-T_{c}-Supraleitermaterialien, insbesondere selten-erd-freie Cuprate mit Phasen geeignet, deren Sprungtemperaturen T_{c} deutlich über der Verdampfungstemperatur des flüssigen Stickstoffs (LN₂) von 77 K liegen. Beispiele hierfür sind das (Bi,Pb)₂Sr₂Ca₂Cu₃Oₓ (Kurzform: Bi(Pb)-2223-Cuprat), das Tl-2223-Cuprat oder das Hg-1223-Cuprat. Für das konkrete Ausführungsbeispiel sei ein HTS-Material auf Basis des sechskomponentigen Stoffsystems (Bi-Pb)-Sr-Ca-Cu-O ausgewählt, wobei unvermeidbare Verunreinigungen der einzelnen Komponenten mit eingeschlossen sind (vgl. z.B. "Supercond. Sci. Technol.", Vol. 4, 1991, Seiten 165 bis 171 oder die EP-A-0 496 281).

Zur Herstellung eines entsprechenden Ausgangspulvers wird von einer bekannten Einwaage ausgegangen, die eine Ausbildung der 110 K-Phase (3-Schichter-Phase) ermöglicht. Um die Stöchiometrie dieser Hoch-T_{c}-Phase zu gewährleisten, werden Oxid- oder Carbonatpulver der einzelnen metallischen Komponenten des ausgewählten Stoffsystems, beispielsweise Pulver aus Bi₂O₃, PbO, SrCO₃, CaO und CuO, so zusammengestellt, daß die einzelnen elementaren Komponenten in dem Bi-Pb-Sr-Ca-Cu-System in folgendem Verhältnis stehen: 1,8:0,4:2,0: (1,8 bis 2,2):3,0. Diese Ausgangspulvermischung wird dann in bekannter Weise in zwei Stufen kalziniert, wobei während z.B. 3 bis 4 Stunden lang bei etwa 800°C und anschließend z.B. 16 Stunden lang bei etwa 820°C geglüht wird. Das so entstandene Kalzinat, das eine Vielzahl von ganz verschiedenen Verbindungen der Komponenten des HTS-Materials, so auch Anteile aus einer 2201- und einer 2202-Phase, aufweist, wird anschließend in einer Planetenkugelmühle zu Pulver vermahlen. Das so gewonnene Ausgangspulver, das als ein Vorprodukt im Hinblick auf das auszubildende Hoch-T_{c}-Supraleitermaterial anzusehen ist und dem gegebenenfalls noch ein Zusatzmaterial wie z.B. Ag-Pulver oder Ag-Folien hinzugefügt werden kann, wird nun in die Bohrungen 3ⱼ eingefüllt und dort verdichtet. Ein entsprechender Aufbau sei allgemein als Ausgangskörper betrachtet, dem in der Figur 1 das Bezugszeichen 5 zugeordnet ist. Dieser Ausgangskörper enthält somit Kerne der Anzahl j aus dem Vorproduktmaterial 4.

Statt des Einpressens von Pulver des Vorproduktes 4 in die Bohrungen 3ⱼ können auch Stäbe aus dem Vorproduktmaterial eingesteckt werden. Entsprechende Stäbe lassen sich z.B. dadurch herstellen, daß man Ausgangspulver des Vorproduktmaterials einem kaltisostatischen Pressen (CIP) unterzieht, den so erhaltenen Preßling z.B. bei 800°C während 3 Stunden vorsintert und dann den entstandenen Sinterkörper auf die Abmessungen der Bohrungen 3ⱼ abdreht.

Die Bohrungen 3ⱼ brauchen nicht hinsichtlich ihrer Form und Zahl dem in Figur 1 dargestellten Ausführungsbeispiel zu entsprechen. So können z.B. auch Bohrungen mit verschiedenen Durchmessern und/oder mit anders geformten, z.B. ovalen oder sechseckigen Querschnitten vorgesehen werden.

Der aus dem Strangpreßbolzen 2 und den Vorproduktfüllungen oder -kernen 4 gebildete Verbund wird anschließend einer Entgasungsbehandlung unterzogen, bevor die gefüllten Bohrungen 3ⱼ mit einem gemeinsamen Deckel z.B. des Durchmessers D gasdicht verschlossen werden. Hierzu ist beispielsweise ein Weichlöten mit einem In-Sn-Lot bei 120°C oder ein Verkleben mit einem Epoxidharz-Kleber bei etwa 130°C möglich. Die dabei vorgesehenen Temperaturen sollten zur Vermeidung einer Rekristallisation des Ag-Matrixmaterials unterhalb der Rekristallisationstemperatur dieses Materials liegen.

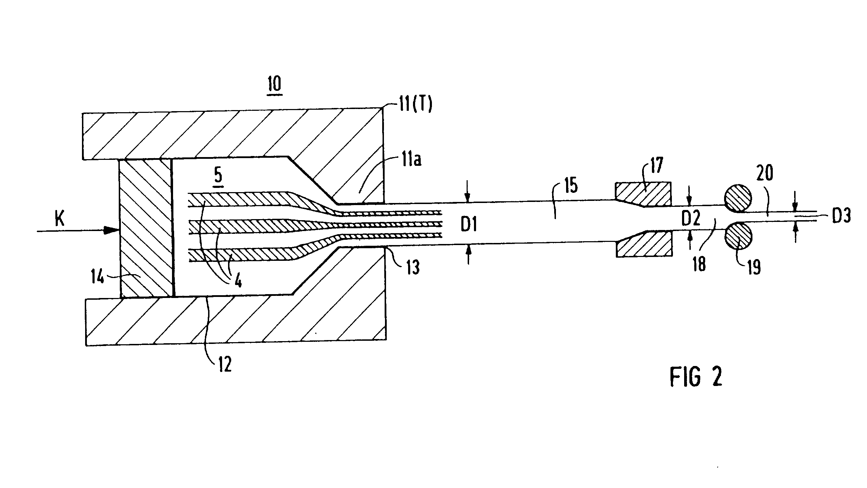

Der so entstandene Ausgangskörper 5 in Form eines Strangpreßkörpers wird nun gemaß dem in Figur 2 dargestellten Längsschnitt mindestens einem Strangpreßschritt unterzogen. Eine entsprechende Strangpreßvorrichtung ist in der Figur allgemein mit 10 bezeichnet. Sie enthält einen Aufnehmer 11, der eine dem Strangpreßkörper 5 angepaßte Ausnehmung 12 des Durchmessers D besitzt. Diese Ausnehmung verjüngt sich an einer Seite zu einer Preßmatrize lla mit einer Öffnung 13 des Durchmessers D1. Von der gegenüberliegenden Seite her wird über einen Stempel 14 ein hinreichend großer Druck mit einer Kraft K auf den Strangpreßkörper 5 ausgeübt, so daß aus der Öffnung 13 der Matrize lla ein stranggepreßter, querschnittsverminderter Zwischenkörper 15 des Durchmessers D1 austritt. Bei dem gewählten Ausführungsbeispiel beträgt die Querschnittsverminderung von D = 48 mm auf D1 = 16 mm oder 19 mm.

Gemaß der Erfindung soll zumindest der erste Verformungsschritt zur Herstellung des Hoch-T_{c}-Supraleiters durch Strangpressen bei einer Temperatur T vorgenommen werden, die unterhalb der Rekristallisationstemperatur des Ag-Matrixmaterials bzw. des Materials des Strangpreßbolzens liegt. Die Rekristallisationstemperatur des Ag-Materials ist dabei vom Verformungsgrad abhängig. Sie liegt im allgemeinen bei etwa 150°C. Vorzugsweise wird das Strangpressen bei Raumtemperatur oder darunterliegender Temperatur durchgeführt. Bei einem Strangpressen unter Raumtemperatur ist eine Kühlung des Aufnehmers 11 und somit eine indirekte Kühlung des Strangpreßkörpers 5 vorzusehen. Als Kühlmedium kommen beispielsweise Wasser oder insbesondere flüssiger Stickstoff (LN₂) von 77 K Siedetemperatur in Frage.

Zur Herstellung des Hoch-T_{c}-Supraleiters schließen sich dem ersten Verformungsschritt durch Strangpressen noch weitere querschnittsvermindernde Verformungsschritte an. Beispielsweise kann ein Stück des Zwischenkörpers 15 einen Strangpreßkörper für einen weiteren Strangpreßvorgang bilden. In Figur 2 ist zur weiteren Verformung des Zwischenkörpers 15 eine Vorrichtung 17 beispielsweise zum Hämmern oder Ziehen angedeutet, um so einen zweiten Zwischenkörper 18 des Durchmessers D2 zu erhalten. Beispielsweise ist die Querschnittsverminderung von D1 = 16 mm auf D2 = 1,7 mm. Der so erhaltene Zwischenkörper 18 kann dann z.B. durch Walzen mittels einer entsprechenden Walzvorrichtung 19 in einen dritten Zwischenkörper 20 mit Bandform überführt werden, wobei die Dicke D3 dieses dritten Zwischenkörpers gemäß dem gewählten Ausführungsbeispiel 0,32 mm betragen kann. Der zweite und der dritte Verformungsschritt werden ebenfalls vorteilhaft bei Temperaturen unterhalb der Rekristallisationstemperatur des Ag-Matrixmaterials ausgeführt. Gegebenenfalls können aber diese Schritte auch bei erhöhter Temperatur vorgenommen werden.

Zur Ausbildung der gewünschten supraleitenden Hoch-T_{c}-Phase in dem Vorproduktmaterial des dritten Zwischenkörpers 20 wird anschließend dieser Körper einer thermo-mechanischen Behandlung unterzogen. Eine solche Behandlung stellt eine Abfolge von Sinter- und Verformungs- ,insbesondere Preßschritten dar. Dabei wird in einer sauerstoffhaltigen Atmosphäre, beispielsweise in Luft, gearbeitet. Die Sinterschritte können im Rahmen des angenommenen Ausführungsbeispiels zur Ausbildung der Bi(Pb)-2223-Phase bei Temperaturen zwischen 810°C und 860°C, vorzugsweise zwischen 820°C und 840°C vorgenommen werden. Auch kann diese Wärmebehandlung zur Ausbildung der gewünschten supraleitenden Hoch-T_{c}-Phase mit den abschließenden Verformungsschritten kombiniert werden.

Neben dem in Figur 2 angedeuteten "Vorwärts"-Strangpressen eines Strangpreßkörpers mit Hilfe der Strangpreßvorrichtung 10 kann ebensogut auch ein als "indirektes" Strangpressen bezeichnetes "Rückwärts"-Strangpressen vorgesehen werden. Eine entsprechende Preßvorrichtung ist in Figur 3 in einem Längsschnitt angedeutet und mit 22 bezeichnet. Diese Vorrichtung weist einen Aufnehmer 23 mit einer Ausnehmung 24 auf, deren Querschnitt dem entsprechenden Querschnitt eines Strangpreßkörpers 25 als Ausgangskörper angepaßt ist. Dieser Ausgangskörper enthält wiederum in Bohrungen eingebrachtes Vorproduktmaterial 4. Die Ausnehmung 24 ist an einer Seite des Aufnehmers mittels eines Druckstückes 26 abgeschlossen. Auf den in der Ausnehmung 24 befindlichen Strangpreßkörper 25 wirkt von dessen freier Stirnseite her eine Preßmatrize 27 so ein, daß durch ihre zentrale Öffnung 28 ein stranggepreßter Zwischenkörper 30 austritt, der dem Zwischenkörper 15 gemäß Figur 2 entspricht und wie dieser weiterverarbeitet wird. Um den Preßdruck mit einer Druckkraft K auf die Preßmatrize 27 auszuüben, dient ein rohrförmiger Stempel 31.

## Patentansprüche

1. Verfahren zur Herstellung eines langgestreckten Supraleiters mit mehreren in einer Matrix aus Ag-Material eingebetteten Leiteradern, die ein Supraleitermaterial mit einer metalloxidischen Hoch-T_{c}-Phase enthalten, bei welchem Verfahren
a) zunächst ein Ausgangskörper aus dem Matrix-Material mit der gewünschten Anzahl an Kernen aus einem Vorprodukt des Supraleitermaterials erstellt wird,
b) darauf dieser Ausgangskörper mehreren Verformungsschritten unterzogen wird
und
c) mindestens eine Wärmebehandlung zur Ausbildung der Hoch-T_{c}-Phase des Supraleitermaterials aus dem Vorprodukt in einer sauerstoffhaltigen Atmosphäre vorgesehen wird,
**dadurch gekennzeichnet**,
- daß zur Erstellung des Ausgangskörpers (5, 25) ein Strangpreßbolzen (2) aus dem Matrix-Material mit der gewünschten Anzahl von Bohrungen (3ⱼ) versehen wird, die anschließend mit dem Vorprodukt (4) des Supraleitermaterials gefüllt und gasdicht verschlossen werden,
und
- daß dann an diesem Ausgangskörper (5, 25) zumindest als ersten Verformungsschritt ein Strangpressen bei einer Temperatur (T) vorgenommen wird, die unterhalb der Rekristallisationstemperatur des Matrix-Materials liegt.

2. Verfahren nach Anspruch 1, **dadurch gekennzeichnet**, daß der Ausgangskörper (5, 25) bei einer Temperatur (T) unter 150°C, vorzugsweise bei Raumtemperatur, stranggepreßt wird.

3. Verfahren nach Anspruch 1, **dadurch gekennzeichnet**, daß der Ausgangskörper (5, 25) beim Strangpressen indirekt, insbesondere mit Hilfe von flüssigem Stickstoff, gekühlt wird.

4. Verfahren nach einem der Ansprüche 1 bis 3, **dadurch gekennzeichnet**, daß sich dem ersten Verformungsschritt durch Strangpressen mindestens ein weiterer Verformungsschritt bei einer Temperatur unterhalb der Rekristallisationstemperatur des Matrix-Materials anschließt.

5. Verfahren nach einem der Ansprüche 1 bis 4, **dadurch gekennzeichnet**, daß sich dem mindestens einen Verfahrensschritt durch Strangpressen mindestens ein weiterer Verfahrensschritt durch Hammern oder Ziehen oder Walzen anschließt.

6. Verfahren nach einem der Ansprüche 1 bis 5, **dadurch gekennzeichnet**, daß ein Vorwärts- oder Rückwärts-Strangpressen vorgesehen wird.

7. Verfahren nach einem der Ansprüche 1 bis 6, **dadurch gekennzeichnet**, daß das Material des Vorproduktes (4) in Form eines Pulvers in die Bohrungen (3ⱼ) des Strangpreßbolzens (2) eingepreßt wird.

8. Verfahren nach einem der Ansprüche 1 bis 6, **dadurch gekennzeichnet**, daß das Material des Vorproduktes (4) in Form von vorgeformten und vorgesinterten Stäben in die Bohrungen (3ⱼ) des Strangpreßbolzens (2) eingesteckt wird.

## Claims

1. Method for producing an elongated superconductor having a plurality of conductor strands which are embedded in a matrix consisting of Ag material and contain a superconducting material having a metal-oxide high-T_{c} phase, in which method
a) first of all, an initial body consisting of the matrix material and having the desired number of cores consisting of a starting product of the superconducting material is prepared,
b) this initial body is thereupon subjected to a plurality of forming steps, and
c) at least one heat treatment is provided in an oxygen-containing atmosphere in order to form the high-T_{c} phase of the superconducting material from the starting product,
characterised
- in that in order to prepare the initial body (5, 25), an extrusion billet (2) consisting of the matrix material is provided with the desired number of bores (3ⱼ), which are then filled with the starting product (4) of the superconducting material and sealed in a gas-tight manner, and
- in that there is then carried out on this initial body (5, 25), at least as a first forming step, an extrusion at a temperature (T) which is below the recrystallisation temperature of the matrix material.

2. Method according to claim 1, characterised in that the initial body (5, 25) is extruded at a temperature (T) below 150°C, preferably at room temperature.

3. Method according to claim 1, characterised in that during the extrusion, the initial body (5, 25) is cooled indirectly, in particular with the aid of liquid nitrogen.

4. Method according to one of the claims 1 to 3, characterised in that there follows on from the first forming step by extrusion at least one further forming step at a temperature below the recrystallisation temperature of the matrix material.

5. Method according to one of the claims 1 to 4, characterised in that there follows on from the at least one step by extrusion at least one further step by hammering or drawing or rolling.

6. Method according to one of the claims 1 to 5, characterised in that a forwards extrusion or reverse extrusion is provided.

7. Method according to one of the claims 1 to 6, characterised in that the material of the starting product (4) is pressed in the form of a powder into the bores (3ⱼ) of the extrusion billet (2).

8. Method according to one of the claims 1 to 6, characterised in that the material of the starting product (4) is inserted in the form of preformed and presintered rods into the bores (3ⱼ) of the extrusion billet (2).

## Revendications

1. Procédé de fabrication d'un supraconducteur allongé à filaments multiples insérés dans une matrice formée d'un matériau à base d'argent et contenant un matériau supraconducteur ayant une phase d'oxyde métallique à Tc élevée, procédé dans lequel
a) on produit d'abord, à partir d'un précurseur du matériau supraconducteur, un corps de base formé du matériau de la matrice et présentant le nombre de noyaux voulus,
b) on soumet ensuite ce corps de base à plusieurs étapes de transformation, et
c) on prévoit au moins un traitement thermique dans une atmosphère contenant de l'oxygène en vue de la formation de la phase à Tc élevée du matériau supraconducteur à partir du précurseur,
caractérisé
- en ce que pour produire le corps de base (5, 25), une ébauche pour extrusion (2) formée du matériau de matrice est munie du nombre d'alésages (3ⱼ) voulus qui sont ensuite remplis avec le précurseur (4) du matériau supraconducteur et fermés de manière étanche au gaz, et
- en ce que l'on procède sur ce corps de base (5, 25), au moins en tant que première étape de transformation, à une extrusion à une température (T) qui est inférieure à la température de recristallisation du matériau de matrice.

2. Procédé selon la revendication 1, caractérisé en ce que le corps de base (5, 25) est extrudé à une température (T) inférieure à 150°C, de préférence à la température ambiante.

3. Procédé selon la revendication 1, caractérisé en ce que le corps de base (5, 25) est refroidi de manière indirecte, notamment à l'aide d'azote liquide, lors de l'extrusion.

4. Procédé selon l'une des revendications 1 à 3, caractérisé en ce qu'au moins une étape de transformation supplémentaire à une température inférieure à la température de recristallisation du matériau de matrice succède à la première étape de transformation par extrusion.

5. Procédé selon l'une des revendications 1 à 4, caractérisé en ce qu'au moins une étape supplémentaire du procédé consistant à étirer, tréfiler ou laminer succède à la - au moins une - étape du procédé par extrusion.

6. Procédé selon l'une des revendications 1 à 5, caractérisé en ce que l'on prévoit une extrusion en avant ou en arrière.

7. Procédé selon l'une des revendications 1 à 6, caractérisé en ce que le matériau du précurseur (4) est injecté sous forme d'une poudre dans les alésages (3ⱼ) de l'ébauche pour extrusion (2).

8. Procédé selon l'une des revendications 1 à 6, caractérisé en ce que le matériau du précurseur (4) est inséré dans les alésages (3ⱼ) de l'ébauche pour extrusion (2) sous forme de barres préformées et préfrittées.
